# EUROPEAN PATENT SPECIFICATION

(11) **EP 4 580 323 B1**
(45) Date of publication and mention of the grant of the patent: **28.10.2026**
(21) Application number: 24220314.9
(22) Date of filing: 16.12.2024
(51) Int. Cl.: H05K 7/14, H04Q 1/10

(54) **NETWORK SWITCH**
NETZWERKSCHALTER
COMMUTATEUR DE RÉSEAU

(30) Priority: 25.12.2023 CN 202311797543
(43) Date of publication of application: 02.07.2025
(73) Proprietor: Beijing Zitiao Network Technology Co., Ltd., Beijing 100190 (CN)
(72) Inventor: CHENG, Chuansheng, Beijing, 100028 (CN); WANG, Yongcan, Beijing, 100028 (CN); SHEN, Dayong, Beijing, 100028 (CN); LIN, Shenglin, Beijing, 100028 (CN); SUN, Zhandong, Beijing, 100028 (CN); WANG, Jian, Beijing, 100028 (CN)
(74) Representative: Marks & Clerk LLP

(56) References cited:
- CN-A- 117 061 463
- US-A1- 2023 164 944

## Description

### FIELD

Embodiments of the present disclosure generally relate to the technical field of network devices, and more particularly, to a network switch.

### BACKGROUND

In a conventional network switch hardware device of a data center, the entire switch generally comprises a switching unit, a management unit, a fan module and a power supply module formed in a chassis. The switching unit is responsible for data exchange and generally comprises a high-speed input/output (HSIO) port and a switching chip. The management unit is responsible for device management and generally comprises management chips such as a central processing unit (CPU), a memory, a solid state drive (SSD), and a programmable logic device (CPLD). The fan module is used for heat dissipation of the entire device. The power supply module is used for power supply of the device.

For a network switch hardware device of a data center, more than 80% of the hardware failure rate of the device occurs in the management unit, for example, devices such as an SSD, a memory, and a CPU in the management unit. In the case where the above components fail and need to be repaired and replaced, the entire chassis needs to be removed from a rack, and the cover of the chassis needs to be opened to try to replace the faulty components. Therefore, the damage of one component of the management unit requires the replacement of the entire chassis. The maintenance of the chassis on and off the rack is cumbersome and the workload is large, resulting in a high maintenance cost.

Document CN 117061463A relates to a network switch in which the management unit and the switching unit can be connected through a first connector and a second connector. When a movement bracket supporting the management unit is pulled out relative to the housing, the first connector is disconnected from the second connector.

### SUMMARY

Embodiments of the present disclosure provide a network switch. The network switch comprises: a housing comprising a bottom plate, a first end plate and a second end plate, the first end plate and second end plate perpendicular to the bottom plate and spaced apart from and opposite to each other; a fan module disposed in the housing adjacent to the second end plate; a power supply module disposed in the housing adjacent to the second end plate; a switching unit at least partially disposed in the housing adjacent to the first end plate, the switching unit comprising a first connector disposed in the housing and a switching unit plate disposed in the housing adjacent to the first end plate, the switching unit plate being parallel to the bottom plate; and a management unit disposed in the housing and movable relative to the second end plate, the switching unit being located outside a path of the management unit moving in a direction away from the second end plate, an end of the management unit adjacent to the second end plate being provided with a second connector capable of mating with the first connector, the management unit comprising a management unit plate provided with the second connector, wherein the second connector is disconnected from the first connector when the management unit is drawn out of the housing through the first end plate in a direction away from the second end plate; and the second connector is connected to the first connector when the management unit is inserted into the housing through the first end plate in a direction toward the second end plate, and wherein the management unit plate is parallel to the switching unit plate, when the management unit plate is adjacent to the bottom plate, the switching unit plate is away from the bottom plate, when the management unit plate is away from the bottom plate, the switching unit plate is adjacent to the bottom plate, the switching unit further comprises an adapter plate connected to the switching unit plate, and the first connector is disposed on the adapter plate.

According to the embodiments of the present disclosure, the management unit and the switching unit are connected by the first connector and the second connector. When the management unit fails, the management unit is drawn out of the housing through the first end plate in a direction away from the second end plate, so that the management unit can be replaced without replacing the entire device, thereby solving the problems of a cumbersome maintenance process and a high maintenance cost of the conventional network switch.

In addition, since the management unit is drawn out of the housing through the first end plate and the fan module and the power supply module are adjacent to the second end plate, the fan module and the power supply module do not need to be plugged and unplugged when the management unit is drawn out of the housing, and the operation steps can also be saved.

It should be understood that the content described in this part is not intended to limit the key features or important features of the embodiments of the present disclosure, nor is it used to limit the scope of the present disclosure. Other features of the present disclosure will become readily understandable through the following description.

### BRIEF DESCRIPTION OF THE DRAWINGS

The above and other features, advantages and aspects of the various embodiments of the present disclosure will become more apparent with reference to the following detailed description in conjunction with the accompanying drawings. In the drawings, the same or similar reference numerals denote the same or similar elements, wherein:
Fig. 1 shows a schematic structural diagram of a management unit along a top-down view according to some embodiments of the present disclosure;
Fig. 2 shows a schematic structural diagram of a network switch along a top-down view according to some embodiments of the present disclosure, where the management unit is adjacent to the second side plate;
Fig. 3 shows a schematic structural diagram of the network switch shown in Fig. 2 along a side view;
Fig. 4 shows a schematic structural diagram of a network switch along a side view according to some other embodiments of the present disclosure, where the management unit is adjacent to the first side plate;
Fig. 5 shows a schematic structural diagram of a network switch along a top-down view according to some other embodiments of the present disclosure, where the management unit plate comprises the first management unit plate and the second management unit plate and is adjacent to the second side plate;
Fig. 6 shows a schematic structural diagram of the network switch shown in Fig. 5 along a side view;
Fig. 7 shows a schematic structural diagram of a network switch along a front view according to some other embodiments of the present disclosure, where the management unit is adjacent to the bottom plate;
Fig. 8 shows a schematic structural diagram of the network switch shown in Fig. 7 along a side view;
Fig. 9 shows a schematic structural diagram of a network switch along a side view according to some other embodiments of the present disclosure, where the management unit plate comprises the first management unit plate and the second management unit plate and is adjacent to the bottom plate;
Fig. 10 shows a schematic structural diagram of a network switch along a front view according to some other embodiments of the present disclosure, where the management unit is away from the bottom plate;
Fig. 11 shows a schematic structural diagram of the network switch shown in Fig. 10 along a side view;
Fig. 12 shows a schematic structural diagram of a network switch along a side view according to some other embodiments of the present disclosure, where the management unit plate comprises the first management unit plate and the second management unit plate and is away from the bottom plate.

### Reference numerals:

100 is a network switch;
1 is a housing, 11 is a first end plate, 111 is a moving slot, 1111 is a first moving slot, 1112 is a second moving slot, 12 is a second end plate, 13 is a top plate, 14 is a bottom plate, 15 is a first side plate, 16 is a second side plate;
2 is a fan module, 21 is a fan unit plate, 22 is a fan device, and 23 is a fan connector;
3 is a power supply module, 31 is a power supply unit plate, 32 is a power supply device, and 33 is a power supply connector;
4 is a switching unit, 41 is a switching unit plate, 411 is a first adapter, 42 is a first connector, 43 is an adapter plate, 431 is a second adapter, and 44 is an input/output port;
5 is a management unit, 51 is a management unit plate, 511 is a first management unit plate, 512 is a second management unit plate, 52 is a second connector, 53 is a moving bracket, 54 is a guide member, 55 is a management interface, and 56 is a handle.

### DETAILED DESCRIPTION

Preferred embodiments of the present disclosure will be described in more detail below with reference to the accompanying drawings. Although preferred embodiments of the present disclosure are shown in the drawings, it should be understood that the present disclosure may be implemented in various forms and should not be limited by the embodiments set forth herein. Rather, these embodiments are provided to make the present disclosure more thorough and complete, and to fully convey the scope of the present disclosure to those skilled in the art.

The term "comprise" used herein and the variations thereof mean an open inclusion, that is, "comprise but not limited to". Unless specifically stated otherwise, the term "or" means "and/or". The term "based on" means "at least partially based on". The term "an example embodiment" and "an embodiment" mean "at least one example embodiment". The term "another embodiment" means "at least one another embodiment". The terms "first" and "second" and the like may refer to different or the same objects.

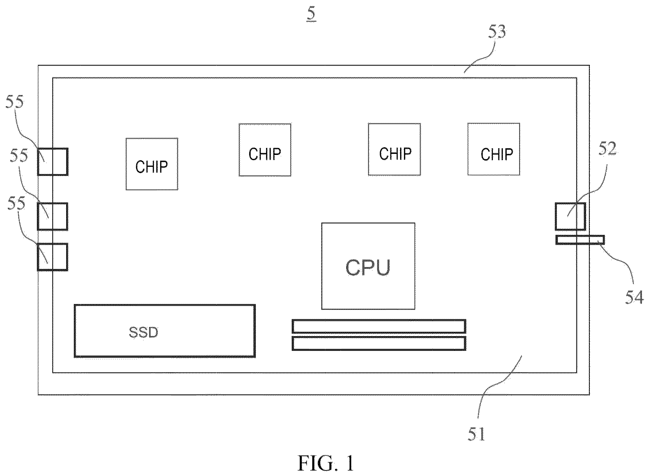

As described above, when a device in the management unit of the conventional network switch fails, the entire chassis needs to be removed from the rack, and the cover of the chassis needs to be opened to try to replace the faulty components. Therefore, the damage of one component of the management unit requires the replacement of the entire chassis, the maintenance of the chassis on and off the rack is cumbersome and the workload is large, resulting in a cumbersome maintenance process and a high maintenance cost. In addition, frequently drawing out the components may also damage an optical module. In addition, since the device assembly is complex, the personnel in the equipment room cannot complete on-site replacement in the absence of tools and accessories. Therefore, it is necessary to send the entire device back to the factory for repair. Sending the entire device back to the factory is slow with high maintenance costs and may be damaged again during transportation, resulting in the problem of failure location. Embodiments of the present disclosure provide a network switch 100 to at least partially solve the above problems. Hereinafter, the principle of the present disclosure will be described in conjunction with Figs. 1 to 12.

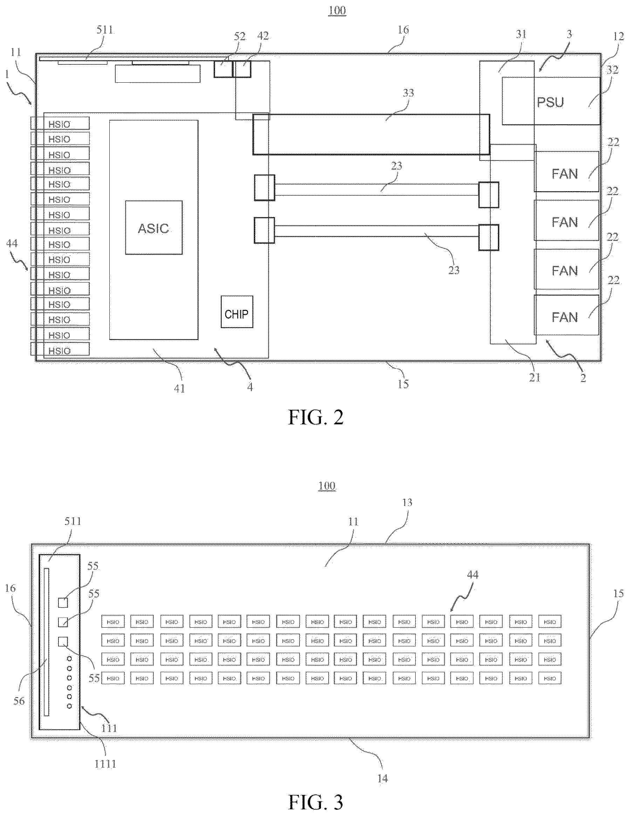

Fig. 1 shows a schematic structural diagram of a management unit 5 along a top-down view according to some embodiments of the present disclosure. Fig. 2 shows a schematic structural diagram of a network switch 100 along a top-down view according to some embodiments of the present disclosure. The management unit 5 shown in Fig. 2 is adjacent to the second side plate 16. Fig. 3 shows a schematic structural diagram of the network switch 100 shown in Fig. 2 along a side view. As shown in Figs. 1 to 3, the network switch 100 described herein generally comprises a housing 1, a fan module 2, a power supply module 3, a switching unit 4, and a management unit 5. The housing 1 is used as a mounting carrier, and the fan module 2, the power supply module 3, the switching unit 4, and the management unit 5 are arranged in the housing 1. The fan module 2 is used for heat dissipation of the entire device, and the power supply module 3 is used for power supply of the device of the network switch 100.

In some embodiments, the housing 1 may comprise a first end plate 11, a second end plate 12, a bottom plate 14, a first side plate 15, and a second side plate 16. The first end plate 11 and the second end plate 12 are arranged at two ends of the bottom plate 14, and the first end plate 11 and the second end plate 12 are spaced apart from each other. The first side plate 15 and the second side plate 16 are arranged at two sides of the bottom plate 14, and the first side plate 15 and the second side plate 16 are spaced apart from each other. The first end plate 11, the second end plate 12, the bottom plate 14, the first side plate 15 and the second side plate 16 together enclose to form the housing 1.

With continued reference to Figs. 2 and 3, in some other embodiments, the housing 1 may further comprise a first end plate 11, a second end plate 12, a top plate 13, a bottom plate 14, a first side plate 15, and a second side plate 16. The first end plate 11 and the second end plate 12 are arranged at two ends of the bottom plate 14, and the first end plate 11 and the second end plate 12 are spaced apart from each other. The top plate 13 and the bottom plate 14 are spaced apart from each other. The first side plate 15 and the second side plate 16 are arranged at two sides of the bottom plate 14, and the first side plate 15 and the second side plate 16 are spaced apart from each other. The first end plate 11, the second end plate 12, the top plate 13, the bottom plate 14, the first side plate 15, and the second side plate 16 together enclose the housing 1.

With continued reference to Fig. 2, in some embodiments, the fan module 2 is adjacent to the second end plate 12, and the fan module 2 is arranged in the housing 1. The power supply module 3 is also adjacent to the second end plate 12, and the power supply module 3 is also arranged in the housing 1. The switching unit 4 is adjacent to the first end plate 11, and the switching unit 4 is at least partially arranged in the housing 1. The management unit 5 is arranged in the housing 1, and the management unit 5 is movable relative to the second end plate 12 to be drawn out or inserted from the first end plate 11. It can be seen that the fan module 2 and the power supply module 3 are respectively adjacent to the second end plate 12, while the switching unit 4 and the management unit 5 are adjacent to the first end plate 11. Therefore, when the management unit 5 is drawn out from the first end plate 11, the fan module 2 and the power supply module 3 do not need to be drawn out.

With continued reference to Fig. 2, further, the switching unit 4 comprises a first connector 42, and the first connector 42 is arranged in the housing 1. The management unit 5 comprises a second connector 52 mating with the first connector 42, and the second connector 52 is located at an end of the management unit 5 adjacent to the second end plate 12. With continued reference to Fig. 3, therefore, when the management unit 5 is drawn out of the housing 1 through the first end plate 11 in a direction away from the second end plate 12, the second connector 52 is disconnected from the first connector 42. When the management unit 5 is inserted into the housing 1 through the first end plate 11 in a direction toward the second end plate 12, the second connector 52 is connected to the first connector 42.

It should be noted that the switching unit 4 may be located outside a path of the management unit 5 moving in a direction away from the second end plate 12, thereby preventing the switching unit 4 from interfering with the management unit 5 being drawn out.

With the above configuration, the management unit 5 and the switching unit 4 are connected by the first connector 42 and the second connector 52. When the management unit 5 fails, the management unit 5 is drawn out of the housing 1 through the first end plate 11 in a direction away from the second end plate 12, so that the management unit 5 can be replaced without replacing the entire device, thereby solving the problems of a cumbersome maintenance process and a high maintenance cost of the conventional network switch. In addition, with the above configuration, it is not necessary to perform the operations of racking and de-racking the device, opening the cover of the chassis to try to replace the faulty components and drawing out the components for many times, and it is also possible to avoid damage to the optical module caused by frequently drawing out the components. In addition, with the above configuration, there is no need to return the entire device to the factory for repair, which avoids the problems of slow repair of the entire device, high maintenance costs and possible secondary damage during transportation which results in the failure location. Finally, since the management unit 5 is drawn out of the housing 1 through the first end plate 11 and the fan module 2 and the power supply module 3 are adjacent to the second end plate 12, when the management unit 5 is drawn out of the housing 1, the fan module 2 and the power supply module 3 do not need to be plugged and unplugged, and the operation steps can also be saved.

With continued reference to Fig. 2, in some embodiments, the switching unit 4 is fixedly arranged in the housing 1. The switching unit 4 is mainly responsible for data exchange, and may comprise a switching unit plate 41 and an input/output port 44. The switching unit plate 41 is fixedly arranged in the housing 1. The input/output port 44 is connected to the switching unit plate 41, and the input/output port 44 may extend out of the housing 1, that is, a part of the input/output port 44 is located in the housing 1. The switching unit plate 41 may be provided with a data exchange chip, and the data exchange chip may comprise at least one of an application-specific integrated circuit (ASIC) and a general-purpose chip.

With continued reference to Fig. 2, specifically, the management unit 5 is arranged in the housing 1, and the management unit 5 is mainly responsible for device management. An end of the management unit 5 away from the second end plate 12 is provided with a handle 56. The handle 56 is switchable between a pressed position and a popped position, wherein the handle 56 is retracted into the management unit 5 when the handle 56 is in the pressed position, that is, the handle 56 is locked. The handle 56 extends out of the management unit 5 and allows the management unit 5 to be drawn out relative to the second end plate 12 when the handle 56 is in the popped position.

With continued reference to Figs. 1 and 3, in some embodiments, the management unit 5 may further comprise a management unit plate 51, a moving bracket 53 and a management interface 55. The moving bracket 53 may be used as a mounting carrier. The management unit plate 51 and the handle 56 may be arranged on the moving bracket 53, and the handle 56 is located at an end of the moving bracket 53 away from the second end plate 12. An end of the management unit plate 51 away from the second end plate 12 may be provided with the management interface 55. The management interface 55 may be connected to a mobile terminal device through a network cable to control the network switch 100 through the mobile terminal device. An end of the management unit plate 51 facing the second end plate 12 is provided with the second connector 52. At least one of a CPU, a memory, an SSD and a CPLD may be arranged on the management unit plate 51.

In some embodiments, a moving slot 111 may be provided on the first end plate 11. The management unit plate 51 may be arranged in the moving slot 111, and the management unit plate 51 is movable relative to the second end plate 12 along the moving slot 111. More specifically, the moving bracket 53 mates with the moving slot 111, and the moving bracket 53 is movable relative to the second end plate 12 along the moving slot 111, thereby driving the management unit plate 51 to move.

With reference to Fig. 2, in some embodiments, the power supply module 3 is used for power supply of the device of the network switch 100. The power supply module 3 comprises a power supply unit plate 31, a power supply device 32 and a power supply connector 33. The power supply device 32 is adjacent to the second end plate 12, and the power supply device 32 is arranged on the power supply unit plate 31. The power supply unit plate 31 and the switching unit plate 41 are connected by the power supply connector 33.

The power supply connector 33 according to the embodiments of the present disclosure may be various types of connectors known at present or available in the future, which is not limited in the embodiments of the present disclosure. For example, in some embodiments, the power supply connector 33 may be a copper bar.

With reference to Fig. 2, in some embodiments, the fan module 2 is used for heat dissipation of the entire device. The fan module 2 comprises a fan unit plate 21, a fan device 22 and a fan connector 23. The fan device 22 is adjacent to the second end plate 12, and the fan device 22 is arranged on the fan unit plate 21. The fan unit plate 21 and the switching unit plate 41 are connected by the fan connector 23.

The fan connector 23 according to the embodiments of the present disclosure may be various types of connectors known at present or available in the future, which is not limited in the embodiments of the present disclosure. For example, in some embodiments, the fan connector 23 may be a cable for power supply to the fan unit plate 21 and transmission of management signals.

Hereinafter, the structure of the network switch 100 according to the embodiments of the present disclosure is exemplarily described in terms of the arrangement form of the management unit 5 relative to the housing 1 and the number of management unit plates 51.

It should be noted that no matter whether the management unit plate 51 comprises the first management unit plate 511 or the second management unit plate 512, each management unit plate 51 may be provided with the management interface 55, the second connector 52 and the guide member 54. In addition, each management unit plate 51 is connected to the moving bracket 53, and each moving bracket 53 is provided with the handle 56.

In addition, when the management unit plate 51 is adjacent to or away from the first side plate 15, the first connector 42 may be arranged on the switching unit plate 41. When the management unit plate 51 is adjacent to or away from the bottom plate 14, the switching unit plate 41 is away from or adjacent to the bottom plate 14. The switching unit 4 may further comprise an adapter plate 43 connected to the switching unit plate 41, and the first connector 42 is arranged on the adapter plate 43.

With continued reference to Figs. 2 and 3, in some embodiments, the moving slot 111 comprises a first moving slot 1111, and the management unit plate 51 comprises a first management unit plate 511. The first management unit plate 511 is arranged in the first moving slot 1111, and the first management unit plate 511 is movable along the first moving slot 1111. The first management unit plate 511 is adjacent to the second side plate 16, that is, the first management unit plate 511 is away from the first side plate 15. The first connector 42 is arranged on the switching unit plate 41. The management unit 5 may be staggered from the input/output port 44 to avoid interference of the input/output port 44 with the movement of the management unit 5.

Obviously, by pulling the first management unit plate 511 in a direction away from the second end plate 12, the first management unit plate 511 can be drawn out of the housing 1 through the first end plate 11, and the second connector 52 is disconnected from the first connector 42. By pushing the first management unit plate 511 in a direction toward the second end plate 12, the first management unit plate 511 can be inserted into the housing 1 through the first end plate 11, and the second connector 52 is connected to the first connector 42.

With reference to Fig. 2, in this embodiment, the second connector 52 may be located on a side of the first management unit plate 511 away from the second side plate 16. Certainly, the second connector 52 may also be located on a side of the first management unit plate 511 facing the second side plate 16.

With reference to Fig. 3, in this embodiment, the guide member 54 may be arranged at an end of the first management unit plate 511 adjacent to the second end plate 12, and the guide member 54 may also be adjacent to the second connector 52. Correspondingly, the switching unit plate 41 may be provided with a guide groove (not shown) mating with the guide member 54. When the guide member 54 mates with the guide groove, the second connector 52 is connected to the first connector 42. With the above configuration, it can be ensured that the second connector 52 of the management unit plate 51 can be accurately and smoothly connected to the first connector 42 of the switching unit plate 41. Obviously, the guide groove may also be arranged on a certain component in the housing 1, which is not limited here.

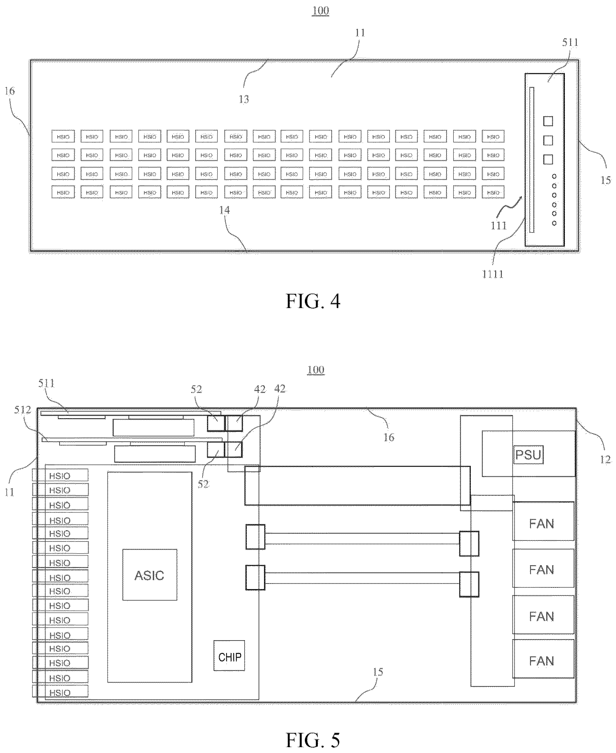

Fig. 4 shows a schematic structural diagram of a network switch 100 along a side view according to some other embodiments of the present disclosure. The management unit 5 shown in Fig. 4 is adjacent to the first side plate 15. With continued reference to Fig. 4, the management unit plate 51 may comprise a first management unit plate 511, and the first management unit plate 511 may also be adjacent to the first side plate 15. The management unit 5 needs to be staggered from the input/output port 44 to avoid interference of the input/output port 44 with the movement of the management unit 5.

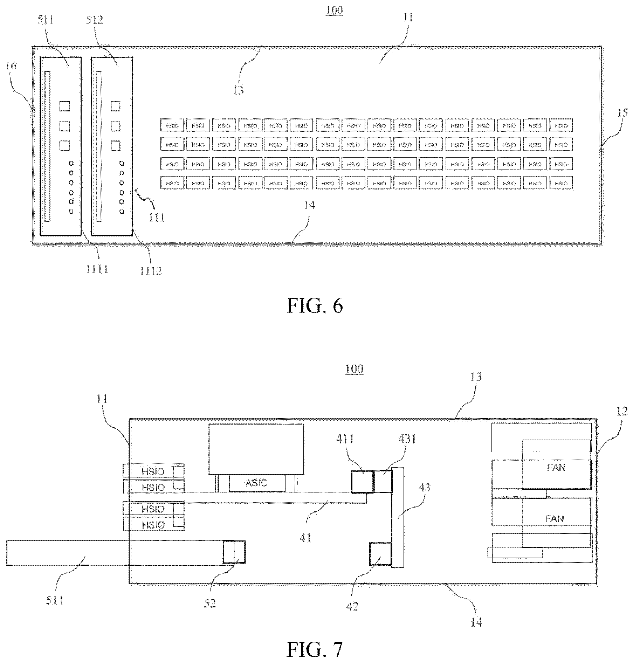

Fig. 5 shows a schematic structural diagram of a network switch 100 along a top-down view according to some other embodiments of the present disclosure. The management unit plate 51 shown in Fig. 5 comprises a first management unit plate 511 and a second management unit plate 512, and the management unit plate 51 is adjacent to the second side plate 16. Fig. 6 shows a schematic structural diagram of the network switch 100 shown in Fig. 5 along a side view. As shown in Figs. 5 and 6, in some other embodiments, the moving slot 111 comprises a first moving slot 1111 and a second moving slot 1112, and the first moving slot 1111 and the second moving slot 1112 are spaced apart from each other. The first management unit plate 511 is arranged in the first moving slot 1111, and the first management unit plate 511 is movable along the first moving slot 1111. The second management unit plate 512 is arranged in the second moving slot 1112, and the second management unit plate 512 is movable along the second moving slot 1112. The first management unit plate 511 and the second management unit plate 512 are respectively adjacent to the second side plate 16. The first connectors 42 are arranged in pairs on the switching unit plate 41, and the paired first connectors 42 are spaced apart from each other. The first management unit plate 511 and the second management unit plate 512 are respectively provided with the second connectors 52. The management unit 5 may be staggered from the input/output port 44 to avoid interference of the input/output port 44 with the movement of the management unit 5.

Obviously, by pulling the first management unit plate 511 and/or the second management unit plate 512 in a direction away from the second end plate 12, the first management unit plate 511 and/or the second management unit plate 512 can be drawn out of the housing 1 through the first end plate 11, and the second connector 52 may be disconnected from the first connector 42. By pushing the first management unit plate 511 and/or the second management unit plate 512 in a direction toward the second end plate 12, the first management unit plate 511 and/or the second management unit plate 512 are/is inserted into the housing 1 through the first end plate 11, and the second connector 52 may be connected to the first connector 42.

In this embodiment, the second connector 52 may be located on a side of the first management unit plate 511 away from the second side plate 16. Certainly, the second connector 52 may also be located on a side of the first management unit plate 511 facing the second side plate 16. In addition, the second connector 52 may be located on a side of the second management unit plate 512 away from the second side plate 16. Certainly, the second connector 52 may also be located on a side of the second management unit plate 512 facing the second side plate 16.

In this embodiment, the guide member 54 may be arranged at an end of the first management unit plate 511 adjacent to the second end plate 12, the guide member 54 may be arranged at an end of the second management unit plate 512 adjacent to the second end plate 12, and the guide member 54 may also be adjacent to the second connector 52. Correspondingly, the switching unit plate 41 is provided with a guide groove mating with the guide member 54. When the guide member 54 mates with the guide groove, the second connector 52 may be connected to the first connector 42. With the above configuration, it can be ensured that the second connector 52 of the management unit plate 51 can be accurately and smoothly connected to the first connector 42 of the switching unit plate 41. Obviously, the guide groove may also be arranged on a certain component in the housing 1, which is not limited here.

In this embodiment, since the first management unit plate 511 and the second management unit plate 512 are simultaneously connected to the switching unit plate 41. For example, for some scenarios with high reliability requirements, when one of the first management unit plate 511 and the second management unit plate 512 fails, the network switch 100 can automatically switch to another management unit plate for access for working, so that the device does not power off, thereby avoiding the problem of device powering off caused by replacing the management unit plate 51.

It should be noted that the first management unit plate 511 and the second management unit plate 512 may also be respectively adjacent to the first side plate 15. Alternatively, one of the first management unit plate 511 and the second management unit plate 512 may be adjacent to the first side plate 15, and the other of the first management unit plate 511 and the second management unit plate 512 may be adjacent to the second side plate 16.

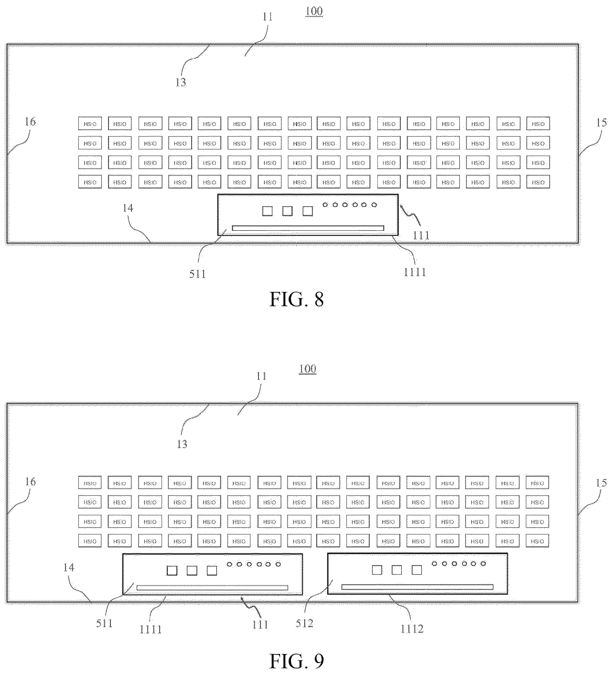

Fig. 7 shows a schematic structural diagram of a network switch 100 along a front view according to some other embodiments of the present disclosure. The management unit 5 in Fig. 7 is adjacent to the bottom plate 14. Fig. 8 shows a schematic structural diagram of the network switch 100 shown in Fig. 7 along a side view. As shown in Figs. 7 and 8, in some other embodiments, the moving slot 111 comprises a first moving slot 1111, and the management unit plate 51 comprises a first management unit plate 511. The first management unit plate 511 is arranged in the first moving slot 1111, and the first management unit plate 511 is movable along the first moving slot 1111. The first management unit plate 511 is adjacent to the bottom plate 14, then the switching unit plate 41 may be away from the bottom plate 14. The management unit 5 is staggered from the input/output port 44 to avoid interference of the input/output port 44 with the movement of the management unit 5. The switching unit 4 further comprises an adapter plate 43 connected to the switching unit plate 41, and the first connector 42 is arranged on the adapter plate 43, that is, the switching unit plate 41 and the management unit plate 51 are connected by the adapter plate 43.

Obviously, by pulling the first management unit plate 511 in a direction away from the second end plate 12, the first management unit plate 511 can be drawn out of the housing 1 through the first end plate 11, and the second connector 52 is disconnected from the first connector 42. By pushing the first management unit plate 511 in a direction toward the second end plate 12, the first management unit plate 511 can be inserted into the housing 1 through the first end plate 11, and the second connector 52 may be connected to the first connector 42.

In this embodiment, the second connector 52 may be located at an end of the first management unit plate 511 facing the second end plate 12. The guide member 54 may be arranged at an end of the first management unit plate 511 adjacent to the second end plate 12, and the guide member 54 may also be adjacent to the second connector 52. Correspondingly, the adapter plate 43 is provided with a guide groove mating with the guide member 54. When the guide member 54 mates with the guide groove, the second connector 52 may be connected to the first connector 42. With the above configuration, it can be ensured that the second connector 52 of the management unit plate 51 can be accurately and smoothly connected to the first connector 42 of the switching unit plate 41. Obviously, the guide groove may also be arranged on a certain component in the housing 1, which is not limited here.

In this embodiment, the switching unit plate 41 is provided with a first adapter 411. An end of the adapter plate 43 adjacent to the switching unit plate 41 is provided with a second adapter 431 that can mate with the first adapter 411. The first connector 42 is arranged at an end of the adapter plate 43 away from the switching unit plate 41.

In this embodiment, the bottom plate 14 may be parallel to the switching unit plate 41. The adapter plate 43 may be arranged parallel to the first end plate 11; or the adapter plate 43 may also be arranged parallel to the first side plate 15, which is not limited here.

Fig. 9 shows a schematic structural diagram of a network switch 100 along a side view according to some other embodiments of the present disclosure. The management unit plate 51 in Fig. 9 comprises a first management unit plate 511 and a second management unit plate 512, and the management unit plate 51 is adjacent to the bottom plate 14. As shown in Fig. 9, the moving slot 111 may further comprise a first moving slot 1111 and a second moving slot 1112, and the first moving slot 1111 and the second moving slot 1112 are spaced apart from each other. The first management unit plate 511 and the second management unit plate 512 are respectively adjacent to the bottom plate 14. The first management unit plate 511 and the second management unit plate 512 are spaced apart from each other in a direction from the first side plate 15 to the second side plate 16. It should be noted that the manner of connection between the management unit plate 51 and the switching unit plate 41 in Fig. 9 is the same as that between the management unit plate 51 and the switching unit plate 41 in Figs. 7 and 8, and details are not described herein.

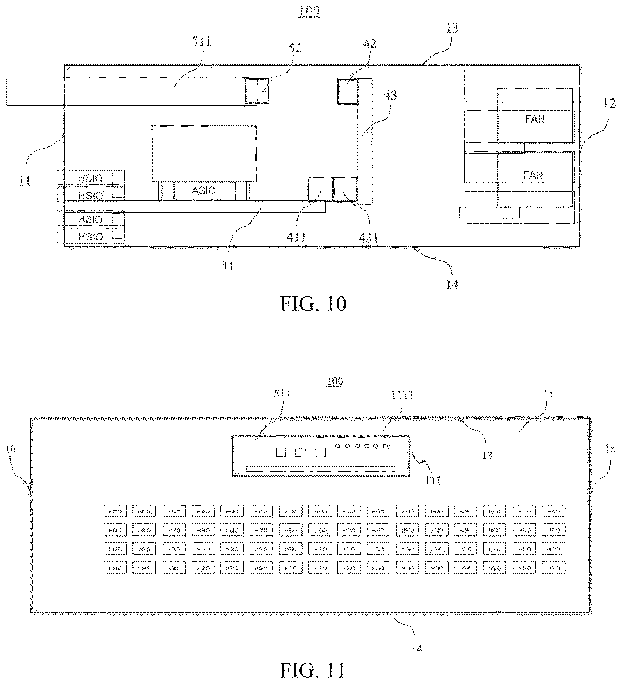

Fig. 10 shows a schematic structural diagram of a network switch 100 along a front view according to some other embodiments of the present disclosure. The management unit 5 in Fig. 10 is away from the bottom plate 14. Fig. 11 shows a schematic structural diagram of the network switch 100 shown in Fig. 10 along a side view. As shown in Figs. 10 and 11, in some other embodiments, the moving slot 111 may comprise a first moving slot 1111, and the management unit plate 51 may comprise a first management unit plate 511. The first management unit plate 511 is arranged in the first moving slot 1111, and the first management unit plate 511 is movable along the first moving slot 1111. The first management unit plate 511 is away from the bottom plate 14, then the switching unit plate 41 is adjacent to the bottom plate 14. The management unit 5 is staggered from the input/output port 44 to avoid interference of the input/output port 44 with the movement of the management unit 5. The switching unit 4 further comprises an adapter plate 43 connected to the switching unit plate 41, and the first connector 42 is arranged on the adapter plate 43, that is, the switching unit plate 41 and the management unit plate 51 are connected by the adapter plate 43.

Obviously, by pulling the first management unit plate 511 in a direction away from the second end plate 12, the first management unit plate 511 is drawn out of the housing 1 through the first end plate 11, and the second connector 52 is disconnected from the first connector 42. By pushing the first management unit plate 511 in a direction toward the second end plate 12, the first management unit plate 511 is inserted into the housing 1 through the first end plate 11, and the second connector 52 may be connected to the first connector 42.

In this embodiment, the second connector 52 may be located at an end of the first management unit plate 511 facing the second end plate 12. The guide member 54 may be arranged at an end of the first management unit plate 511 adjacent to the second end plate 12, and the guide member 54 may also be adjacent to the second connector 52. Correspondingly, the adapter plate 43 is provided with a guide groove mating with the guide member 54. When the guide member 54 mates with the guide groove, the second connector 52 may be connected to the first connector 42. With the above configuration, it can be ensured that the second connector 52 of the management unit plate 51 can be accurately and smoothly connected to the first connector 42 of the switching unit plate 41. Obviously, the guide groove may also be arranged on a certain component in the housing 1, which is not limited here.

In this embodiment, the switching unit plate 41 is provided with a first adapter 411. An end of the adapter plate 43 adjacent to the switching unit plate 41 is provided with a second adapter 431 that can mate with the first adapter 411. The first connector 42 is arranged at an end of the adapter plate 43 away from the switching unit plate 41.

In this embodiment, the bottom plate 14 may be parallel to the switching unit plate 41. The adapter plate 43 may be arranged parallel to the first end plate 11; or the adapter plate 43 may also be arranged parallel to the first side plate 15, which is not limited here.

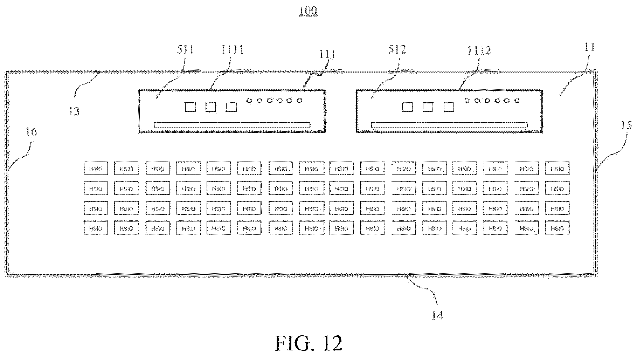

Fig. 12 shows a schematic structural diagram of a network switch 100 along a side view according to some other embodiments of the present disclosure. The management unit plate 51 in Fig. 12 comprises a first management unit plate 511 and a second management unit plate 512, and the management unit plate 51 is away from the bottom plate 14. As shown in Fig. 12, the moving slot 111 may further comprise a first moving slot 1111 and a second moving slot 1112, and the first moving slot 1111 and the second moving slot 1112 are spaced apart from each other. The management unit plate 51 may further comprise a first management unit plate 511 and a second management unit plate 512, and the first management unit plate 511 and the second management unit plate 512 are respectively away from the bottom plate 14. The first management unit plate 511 and the second management unit plate 512 are spaced apart from each other in a direction from the first side plate 15 to the second side plate 16. It should be noted that the manner of the connection between the management unit plate 51 and the switching unit plate 41 in Fig. 12 is the same as that between the management unit plate 51 and the switching unit plate 41 in Figs. 10 and 11, and details are not described herein.

The design layout of the management unit 5 and the switching unit 4 according to the embodiments of the present disclosure may be applied to various network switches 100, so that when components on the management unit plate 51 fail, the entire device needs to be replaced, resulting in a cumbersome maintenance process and a high maintenance cost. It should be understood that the design layout of the management unit 5 and the switching unit 4 according to the embodiments of the present disclosure may also be applied to other components, which is not limited in the embodiments of the present disclosure.

The invention is set out in the appended set of claims.

The foregoing has described the embodiments of the present disclosure. The selection of terms used herein is intended to best explain the principles, practical applications or technical improvements to the market of the embodiments, or to make other ordinary skilled in the art understand the embodiments disclosed herein.

## Claims

1. A network switch (100), comprising:
a housing (1) comprising a bottom plate (14), a first end plate (11) and a second end plate (12), the first end plate (11) and second end plate (12) perpendicular to the bottom plate (14) and spaced apart from and opposite to each other;
a fan module (2) disposed in the housing (1) adjacent to the second end plate (12);
a power supply module (3) disposed in the housing (1) adjacent to the second end plate (12);
a switching unit (4) at least partially disposed in the housing (1) adjacent to the first end plate (11), the switching unit (4) comprising a first connector (42) disposed in the housing (1) and a switching unit plate (41) disposed in the housing (1) adjacent to the first end plate (11), the switching unit plate (41) being parallel to the bottom plate (14); and
a management unit (5) disposed in the housing (1) and movable relative to the second end plate (12), the switching unit (4) being located outside a path of the management unit (5) moving in a direction away from the second end plate (12), an end of the management unit (5) adjacent to the second end plate (12) being provided with a second connector (52) capable of mating with the first connector (42), the management unit (5) comprising a management unit plate (51) provided with the second connector (52), wherein the second connector (52) is disconnected from the first connector (42) when the management unit (5) is drawn out of the housing (1) through the first end plate (11) in a direction away from the second end plate (12); and the second connector (52) is connected to the first connector (42) when the management unit (5) is inserted into the housing (1) through the first end plate (11) in a direction toward the second end plate (12), and wherein the management unit plate (51) is parallel to the switching unit plate (41), when the management unit plate (51) is adjacent to the bottom plate (14), the switching unit plate (41) is away from the bottom plate (14), when the management unit plate (51) is away from the bottom plate (14), the switching unit plate (41) is adjacent to the bottom plate, the switching unit (4) further comprises an adapter plate (43) connected to the switching unit plate (41), and the first connector (42) is disposed on the adapter plate (43).

2. The network switch (100) according to claim 1, wherein a moving slot (111) is provided on the first end plate (11), and the management unit plate (51) is disposed in the moving slot (111) and is movable relative to the second end plate (12) along the moving slot (111).

3. The network switch (100) according to claim 2, wherein the moving slot (111) comprises a first moving slot (1111) and a second moving slot (1112) spaced apart from each other, the management unit plate (51) comprises a first management unit plate (511) disposed in the first moving slot (1111) and a second management unit plate (512) disposed in the second moving slot (1112), and the management unit plate (511) and the second management unit plate (512) are respectively provided with the second connector (52).

4. The network switch (100) according to claim 2, wherein the housing (1) further comprises a first side plate (15) and a second side plate (16) spaced apart from each other, and the first end plate (11), the second end plate (12), the bottom plate (14), the first side plate (15) and the second side plate (16) together form the housing (1).

5. The network switch (100) according to claim 4, wherein an end of the management unit plate (51) adjacent to the second end plate (12) is provided with a guide member (54), the switching unit plate (41) is provided with a guide groove mating with the guide member (54), and when the guide member (54) mates with the guide groove, the second connector (52) is connected to the first connector (42).

6. The network switch (100) according to claim 4, wherein the first connector (42) is disposed on the switching unit plate (41) when the management unit plate (51) is adjacent to or away from the first side plate (15).

7. The network switch (100) according to claim 4, wherein the switching unit plate (41) is provided with a first adapter (411), an end of the adapter plate (43) adjacent to the switching unit plate (41) is provided with a second adapter (431) mating with the first adapter (411), and an end of the adapter plate (43) away from the switching unit plate (41) is provided with the first connector (42).

8. The network switch (100) according to claim 4, wherein the adapter plate (43) is arranged in parallel to the first end plate (11); or
the adapter plate (43) is arranged in parallel to the first side plate (15).

9. The network switch (100) according to claim 2, wherein an end of the management unit plate (51) away from the second end plate (12) is provided with a management interface (55).

10. The network switch (100) according to claim 2, wherein the management unit (5) further comprises a handle (56) arranged away from the second end plate (12), and the handle (56) is switchable between a pressed position and a popped position, wherein the handle (56) is retracted into the management unit (5) when the handle (56) is in the pressed position, and the handle (56) extends out of the management unit (5) and allows the management unit (5) to be drawn out relative to the second end plate (12) when the handle (56) is in the popped position.

## Patentansprüche

1. Netzwerk-Switch (100), umfassend:
ein Gehäuse (1), umfassend eine Bodenplatte (14), eine erste Endplatte (11) und eine zweite Endplatte (12), wobei die erste Endplatte (11) und die zweite Endplatte (12) senkrecht zur Bodenplatte (14) und voneinander beabstandet und einander gegenüberliegend sind;
ein Lüftermodul (2), das im Gehäuse (1) neben der zweiten Endplatte (12) angeordnet ist;
ein Stromversorgungsmodul (3), das im Gehäuse (1) neben der zweiten Endplatte (12) angeordnet ist;
eine Schalteinheit (4), die zumindest teilweise im Gehäuse (1) neben der ersten Endplatte (11) angeordnet ist, wobei die Schalteinheit (4) einen ersten Verbinder (42), der im Gehäuse (1) angeordnet ist, und eine Schalteinheitsplatte (41), die im Gehäuse (1) neben der ersten Endplatte (11) angeordnet ist, umfasst, wobei die Schalteinheitsplatte (41) parallel zur Bodenplatte (14) ist; und
eine Steuereinheit (5), die im Gehäuse (1) angeordnet und relativ zur zweiten Endplatte (12) beweglich ist, wobei sich die Schalteinheit (4) außerhalb eines Bewegungspfads der Steuereinheit (5) befindet, die sich in einer Richtung weg von der zweiten Endplatte (12) bewegt, wobei ein Ende der Steuereinheit (5) neben der zweiten Endplatte (12) mit einem zweiten Verbinder (52) versehen ist, der zum Zusammenpassen mit dem ersten Verbinder (42) in der Lage ist, wobei die Steuereinheit (5) eine Steuereinheitsplatte (51) umfasst, die mit dem zweiten Verbinder (52) versehen ist, wobei der zweite Verbinder (52) vom ersten Verbinder (42) getrennt wird, wenn die Steuereinheit (5) durch die erste Endplatte (11) in einer Richtung weg von der zweiten Endplatte (12) aus dem Gehäuse (1) herausgezogen wird; und der zweite Verbinder (52) mit dem ersten Verbinder (42) verbunden ist, wenn die Steuereinheit (5) durch die erste Endplatte (11) in einer Richtung hin zu der zweiten Endplatte (12) in das Gehäuse (1) eingeführt wird, und wobei die Steuereinheitsplatte (51) parallel zur Schalteinheitsplatte (41) ist, wenn die Steuereinheitsplatte (51) neben der Bodenplatte (14) ist, die Schalteinheitsplatte (41) von der Bodenplatte (14) entfernt ist, wenn die Steuereinheitsplatte (51) von der Bodenplatte (14) entfernt ist, die Schalteinheitsplatte (41) neben der Bodenplatte ist, wobei die Schalteinheit (4) weiter eine Adapterplatte (43) umfasst, die mit der Schalteinheitsplatte (41) verbunden ist, und der erste Verbinder (42) auf der Adapterplatte (43) angeordnet ist.

2. Netzwerk-Switch (100) nach Anspruch 1, wobei auf der ersten Endplatte (11) ein beweglicher Schlitz (111) versehen ist und die Steuereinheitsplatte (51) in dem beweglichen Schlitz (111) angeordnet ist und relativ zur zweiten Endplatte (12) entlang des beweglichen Schlitzes (111) beweglich ist.

3. Netzwerk-Switch (100) nach Anspruch 2, wobei der bewegliche Schlitz (111) einen ersten beweglichen Schlitz (1111) und einen zweiten beweglichen Schlitz (1112) umfasst, die voneinander beabstandet sind, die Steuereinheitsplatte (51) eine erste Steuereinheitsplatte (511), die im ersten beweglichen Schlitz (1111) angeordnet ist, und eine zweite Steuereinheitsplatte (512), die im zweiten beweglichen Schlitz (1112) angeordnet ist, umfasst und die Steuereinheitsplatte (511) und die zweite Steuereinheitsplatte (512) jeweils mit dem zweiten Verbinder (52) versehen sind.

4. Netzwerk-Switch (100) nach Anspruch 2, wobei das Gehäuse (1) weiter eine erste Seitenplatte (15) und eine zweite Seitenplatte (16) umfasst, die voneinander beabstandet sind, und die erste Endplatte (11), die zweite Endplatte (12), die Bodenplatte (14), die erste Seitenplatte (15) und die zweite Seitenplatte (16) zusammen das Gehäuse (1) bilden.

5. Netzwerk-Switch (100) nach Anspruch 4, wobei ein Ende der Steuereinheitsplatte (51) neben der zweiten Endplatte (12) mit einem Führungselement (54) versehen ist, die Schalteinheitsplatte (41) mit einer Führungsnut versehen ist, die mit dem Führungselement (54) zusammenpasst, und wenn das Führungselement (54) mit der Führungsnut zusammenpasst, der zweite Verbinder (52) mit dem ersten Verbinder (42) verbunden wird.

6. Netzwerk-Switch (100) nach Anspruch 4, wobei der erste Verbinder (42) auf der Schalteinheitsplatte (41) angeordnet ist, wenn sich die Steuereinheitsplatte (51) neben oder entfernt von der ersten Seitenplatte (15) befindet.

7. Netzwerk-Switch (100) nach Anspruch 4, wobei die Schalteinheitsplatte (41) mit einem ersten Adapter (411) versehen ist, ein Ende der Adapterplatte (43) neben der Schalteinheitsplatte (41) mit einem zweiten Adapter (431) versehen ist, der mit dem ersten Adapter (411) zusammenpasst, und ein Ende der Adapterplatte (43), entfernt von der Schalteinheitsplatte (41), mit dem ersten Verbinder (42) versehen ist.

8. Netzwerk-Switch (100) nach Anspruch 4, wobei die Adapterplatte (43) parallel zur ersten Endplatte (11) angeordnet ist; oder
die Adapterplatte (43) parallel zur ersten Seitenplatte (15) angeordnet ist.

9. Netzwerk-Switch (100) nach Anspruch 2, wobei ein Ende der Steuereinheitsplatte (51), entfernt von der zweiten Endplatte (12), mit einer Steuerschnittstelle (55) versehen ist.

10. Netzwerk-Switch (100) nach Anspruch 2, wobei die Steuereinheit (5) weiter einen von der zweiten Endplatte (12) entfernt angeordneten Griff (56) umfasst und der Griff (56) zwischen einer gedrückten Position und einer ausgefahrenen Position umschaltbar ist, wobei der Griff (56) in die Steuereinheit (5) zurückgezogen ist, wenn sich der Griff (56) in der gedrückten Position befindet, und sich der Griff (56) aus der Steuereinheit (5) heraus erstreckt und es ermöglicht, dass die Steuereinheit (5) relativ zur zweiten Endplatte (12) herausgezogen wird, wenn sich der Griff (56) in der ausgefahrenen Position befindet.

## Revendications

1. Commutateur réseau (100), comprenant :
un boîtier (1) comprenant une plaque inférieure (14), une première plaque d'extrémité (11) et une seconde plaque d'extrémité (12), la première plaque d'extrémité (11) et la seconde plaque d'extrémité (12) étant perpendiculaires à la plaque inférieure (14) et espacées et opposées l'une à l'autre ;
un module de ventilateur (2) disposé dans le boîtier (1) adjacent à la seconde plaque d'extrémité (12) ;
un module d'alimentation( 3) disposé dans le boîtier (1) adjacent à la seconde plaque d'extrémité (12) ;
une unité de commutation (4) disposée au moins partiellement dans le boîtier (1) de manière adjacente à la première plaque d'extrémité (11), l'unité de commutation (4) comprenant un premier connecteur (42) disposé dans le boîtier (1) et une plaque d'unité de commutation (41) disposée dans le boîtier (1) de manière adjacente à la première plaque d'extrémité (11), la plaque d'unité de commutation (41) étant parallèle à la plaque inférieure (14) ; et
une unité de gestion (5) disposée dans le boîtier (1) et mobile par rapport à la seconde plaque d'extrémité (12), l'unité de commutation (4) étant située à l'extérieur d'une trajectoire de l'unité de gestion (5) se déplaçant dans une direction s'éloignant de la seconde plaque d'extrémité (12), une extrémité de l'unité de gestion (5) adjacente à la seconde plaque d'extrémité (12) étant munie d'un second connecteur (52) capable de s'accoupler avec le premier connecteur (42), l'unité de gestion (5) comprenant une plaque d'unité de gestion (51) munie du second connecteur (52), dans lequel le second connecteur (52) est déconnecté du premier connecteur (42) lorsque l'unité de gestion (5) est retirée du boîtier (1) à travers la première plaque d'extrémité (11) dans une direction s'éloignant de la seconde plaque d'extrémité (12) ; et le second connecteur (52) est connecté au premier connecteur (42) lorsque l'unité de gestion (5) est insérée dans le boîtier (1) à travers la première plaque d'extrémité (11) en direction de la seconde plaque d'extrémité (12), et dans lequel la plaque de l'unité de gestion (51) est parallèle à la plaque d'unité de commutation (41), lorsque la plaque d'unité de gestion (51) est adjacente à la plaque inférieure (14), la plaque d'unité de commutation (41) est éloignée de la plaque inférieure (14), lorsque la plaque d'unité de gestion (51) est éloignée de la plaque inférieure (14), la plaque d'unité de commutation (41) est adjacente à la plaque inférieure, l'unité de commutation (4) comprend en outre une plaque d'adaptation (43) connectée à la plaque d'unité de commutation (41), et le premier connecteur (42) est disposé sur la plaque d'adaptation (43).

2. Commutateur réseau (100) selon la revendication 1, dans lequel une fente mobile (111) est prévue sur la première plaque d'extrémité (11) et la plaque d'unité de gestion (51) est disposée dans la fente mobile (111) et est mobile par rapport à la seconde plaque d'extrémité (12) le long de la fente mobile (111).

3. Commutateur réseau (100) selon la revendication 2, dans lequel la fente mobile (111) comprend une première fente mobile (1111) et une seconde fente mobile (1112) espacées l'une de l'autre, la plaque d'unité de gestion (51) comprend une première plaque d'unité de gestion (511) disposée dans la première fente mobile (1111) et une seconde plaque d'unité de gestion (512) disposée dans la seconde fente mobile (1112) et la plaque d'unité de gestion (511) et la seconde plaque d'unité de gestion (512) sont respectivement munies du second connecteur (52).

4. Commutateur réseau (100) selon la revendication 2, dans lequel le boîtier (1) comprend en outre une première plaque latérale (15) et une seconde plaque latérale (16) espacées l'une de l'autre et la première plaque d'extrémité (11), la seconde plaque d'extrémité (12), la plaque inférieure (14), la première plaque latérale (15) et la seconde plaque latérale (16) forment ensemble le boîtier (1).

5. Commutateur réseau (100) selon la revendication 4, dans lequel une extrémité de la plaque de l'unité de gestion (51) adjacente à la seconde plaque d'extrémité (12) est munie d'un élément de guidage (54), la plaque d'unité de commutation (41) est munie d'une rainure de guidage s'accouplant avec l'élément de guidage (54) et lorsque l'élément de guidage (54) s'emboîte dans la rainure de guidage, le second connecteur (52) est connecté au premier connecteur (42).

6. Commutateur réseau (100) selon la revendication 4, dans lequel le premier connecteur (42) est disposé sur la plaque de l'unité de commutation (41) lorsque la plaque d'unité de gestion (51) est adjacente ou éloignée de la première plaque latérale (15).

7. Commutateur réseau (100) selon la revendication 4, dans lequel la plaque de d'unité de commutation (41) est munie d'un premier adaptateur (411), une extrémité de la plaque d'adaptation (43) adjacente à la plaque d'unité de commutation (41) est munie d'un second adaptateur (431) s'accouplant avec le premier adaptateur (411) et une extrémité de la plaque d'adaptation (43) éloignée de la plaque d'unité de commutation (41) est munie du premier connecteur (42).

8. Commutateur réseau (100) selon la revendication 4, dans lequel la plaque d'adaptation (43) est disposée parallèlement à la première plaque d'extrémité (11) ; ou
la plaque d'adaptation (43) est disposée parallèlement à la première plaque latérale (15).

9. Commutateur réseau (100) selon la revendication 2, dans lequel une extrémité de la plaque d'unité de gestion (51) éloignée de la seconde plaque d'extrémité (12) est munie d'une interface de gestion (55).

10. Commutateur réseau (100) selon la revendication 2, dans lequel l'unité de gestion (5) comprend en outre une poignée (56) disposée à distance de la seconde plaque d'extrémité (12) et la poignée (56) est commutable entre une position enfoncée et une position relevée, dans lequel la poignée (56) est rétractée dans l'unité de gestion (5) lorsque la poignée (56) est en position enfoncée et la poignée (56) s'étend hors de l'unité de gestion (5) et permet à l'unité de gestion (5) d'être tirée par rapport à la seconde plaque d'extrémité (12) lorsque la poignée (56) est en position relevée.
